# EUROPÄISCHE PATENTSCHRIFT

(11) **EP 1 415 342 B1**
(45) Veröffentlichungstag und Bekanntmachung des Hinweises auf die Patenterteilung: **07.06.2006**
(21) Anmeldenummer: 02759856.4
(22) Anmeldetag: 22.07.2002
(51) Int. Cl.: H01L 23/467, H05K 7/20

(54) **EINRICHTUNG ZUR KÜHLUNG VON GEHAUSEN, RAUMEN, BAUTEILEN, MEDIEN U. DGL**
DEVICE FOR COOLING HOUSINGS, AREAS, COMPONENTS, MEDIA AND THE LIKE
DISPOSITIF DE REFROIDISSEMENT DE BOITIERS, PIECES, COMPOSANTS, FLUIDES ET SIMILAIRES

(30) Priorität: 30.07.2001 AT 118901
(43) Veröffentlichungstag der Anmeldung: 06.05.2004
(73) Patentinhaber: BISTEKOS, Michael-Georg, A-1190 Wien (AT)
(72) Erfinder: BISTEKOS, Michael-Georg, A-1190 Wien (AT)
(74) Vertreter: Hehenberger, Reinhard
(86) Internationale Anmeldenummer: PCT/AT2002/000216
(87) Internationale Veröffentlichungsnummer: WO 2003/012866

(56) Entgegenhaltungen:
- EP-A- 1 020 911
- US-A- 5 493 473
- US-B1- 6 252 769

## Beschreibung

Die Erfindung betrifft eine Einrichtung zur Klimatisierung von Gehäusen, Räumen, Bauteilen, Medien u.dgl., insbesondere zur Kühlung von in elektrischen bzw. elektronischen Anlagen und Geräten befindlichen Bauelementen, mittels eines Fluidstroms, insbesondere eines Luft- oder Flüssigkeitsstroms, mit einer Kammer, welche mindestens eine verstellbare Membran und wenigstens eine Öffnung in einer Wand der Kammer aufweist.

Es besteht vielfach das Erfordernis, in Anlagen, Geräten u.dgl. befindliche Bauteile oder Medien zu klimatisieren, insbesondere Überhitzungen derselben zu vermeiden bzw. bestimmte Temperaturbereiche einzuhalten. Dies gilt insbesondere für in Anlagen, Geräten u.dgl. befindliche, elektrische bzw. elektronische Bauteile, welche sich während des Betriebes so erhitzen könnten, dass deren Funktionsfähigkeit beeinträchtigt wird.

Aus der EP-A-1 020 911 ist eine gattungsgemäße Einrichtung bekannt, bei der die Öffnung direkt in den Raum mündet, in dem die zu kühlenden Teile angeordnet sind. Eine effektive Kühlung ist mit dieser Einrichtung nur schwer möglich, da die Kühlluft durch die Schwingung der Membran immer vor- und zurückgesaugt wird, ein effektiver Austausch von Kühlluft daher nicht erfolgt.

Es ist bekannt, in Anlagen, Geräten u.dgl. Ventilatoren vorzusehen, durch welche eine Luftströmung erzeugt wird, mittels welcher in diesen Anlagen, Geräten u.dgl. durch elektrische Bauteile erzeugte Wärme abgeführt wird. Den Ventilatoren haftet jedoch der Nachteil an, dass durch deren Betrieb im hörbaren Bereich liegende Schwingungen erzeugt werden, welche als Summton oder als Pfeifton so stark wahrnehmbar sind, dass sie für Personen, welche sich im Bereich der Anlagen, Geräte u.dgl. befinden, äußerst störend sind oder sogar eine Schädigung des Hörvermögens dieser Personen verursachen können.

Der gegenständlichen Erfindung liegt somit die Aufgabe zugrunde, eine gattungsgemäße Einrichtung zu schaffen, mittels welcher diese störenden oder schädigenden Geräusche vermieden oder wenigstens stark vermindert werden können.

Dies wird erfindungsgemäß durch eine Vorrichtung mit den Merkmalen des Anspruches 1 erreicht.

Erfindungsgemäß ist eine Kammer vorgesehen, welche mindestens eine verstellbare Membran und wenigstens eine Öffnung aufweist, die in einem Abstand vor einer Scheidewand mit einer Öffnung vorgesehen ist.

Durch die Verstellung bzw. Verschiebung der mindestens einen Membran wird ein Fluid, zum Beispiel Luft oder Flüssigkeit, in die Kammer abwechselnd eingesaugt und ausgestoßen, wobei durch die unterschiedliche Strömungseigenschaft des Einsaugvorganges gegenüber dem Ausstoßvorgang und in Abhängigkeit des Abstands zwischen der Öffnung der Kammer und der Öffnung der Scheidewand ein Luft- oder Flüssigkeitsstrom von der einen Seite der Scheidewand zur anderen entsteht.

Zum Verstellen bzw. Verschieben der mindestens einen Membran kann zum Beispiel ein Elektromagnet verwendet werden.

Nach einer bevorzugten Ausführungsform der Erfindung sind die Öffnungen der Kammer rohrförmig oder kegelstumpfförmig oder trompetenförmig ausgebildet.

Nach einer weiteren bevorzugten Ausführungsform der Erfindung ist der Durchmesser der Öffnungen bzw. der Mündung der Öffnungen in der Scheidewand größer ist als der Durchmesser der Öffnungen bzw. der Mündung der Öffnungen der Kammer.

Bei der Erfindung können die Öffnungen in der Scheidewand rohr-, kegelstumpf- oder trompetenförmig sowie rund oder flach bzw. länglich ausgeführt sein.

Nach einer weiteren bevorzugten Ausführungsform der Erfindung kann die Scheidewand als Seitenwand eines die zu kühlenden Bauteile umfassenden Gehäuses ausgebildet sein, wodurch ein Fluidstrom durch das Gehäuse bewirkt wird. Die Kammer kann innerhalb sowie außerhalb eines Gehäuses vorgesehen sein.

Nach einer weiteren bevorzugten Ausführungsform der Erfindung wird die Scheidewand durch wenigstens einen, vorzugsweise mehrere rohrförmige, kegelstumpfförmige oder trompetenförmige Durchgänge gebildet.

Nach einer weiteren bevorzugten Ausführungsform der Erfindung können in der Kammer zwei einander gegenüberliegende und zugeordnete Membrane vorgesehen sein, welche synchron zueinander bzw. auseinander bewegbar sind.

Nach einer weiteren bevorzugten Ausführungsform kann die Membran durch einen Wandteil der Kammer gebildet werden, der relativ zu den benachbarten Teilen der Wand der Kammer bewegbar ist, wobei zwischen den benachbarten Rändern des Wandteiles und der Wand der Kammer ein Spalt gebildet ist, der eine im Querschnitt rohrförmige Öffnung bildet, die der Öffnung in der Scheidewand unmittelbar gegenüber liegt.

Weiter bevorzugte Ausführungsformen sind Gegenstand der übrigen Unteransprüche.

Nachfolgend wird die Erfindung anhand von mehreren in der Zeichnung dargestellten Ausführungsbeispielen näher erläutert.

Es zeigt:
- Fig. 1: eine erste Ausführungsform einer erfindungsgemäßen Einrichtung in axonometrischer Darstellung;
- Fig. la: die erfindungsgemäße Einrichtung gemäß Fig. 1 im Schnitt;
- Fig. 2: eine zweite Ausführungsform einer erfindungsgemäßen Einrichtung in axonometrischer Darstellung;
- Fig. 2a: die erfindungsgemäße Einrichtung gemäß Fig. 2 im Schnitt;
- Fig. 3: eine dritte Ausführungsform einer erfindungsgemäßen Einrichtung im Schnitt;
- Fig. 4: eine vierte Ausführungsform einer erfindungsgemäßen Einrichtung im Schnitt;
- Fig. 5a und 5b: die erfindungsgemäße Einrichtung gemäß Fig. 3 in zwei Betriebsstellungen und im Schnitt;
- Fig. 6: eine fünfte Ausführungsform einer erfindungsgemäßen Einrichtung im Schnitt.

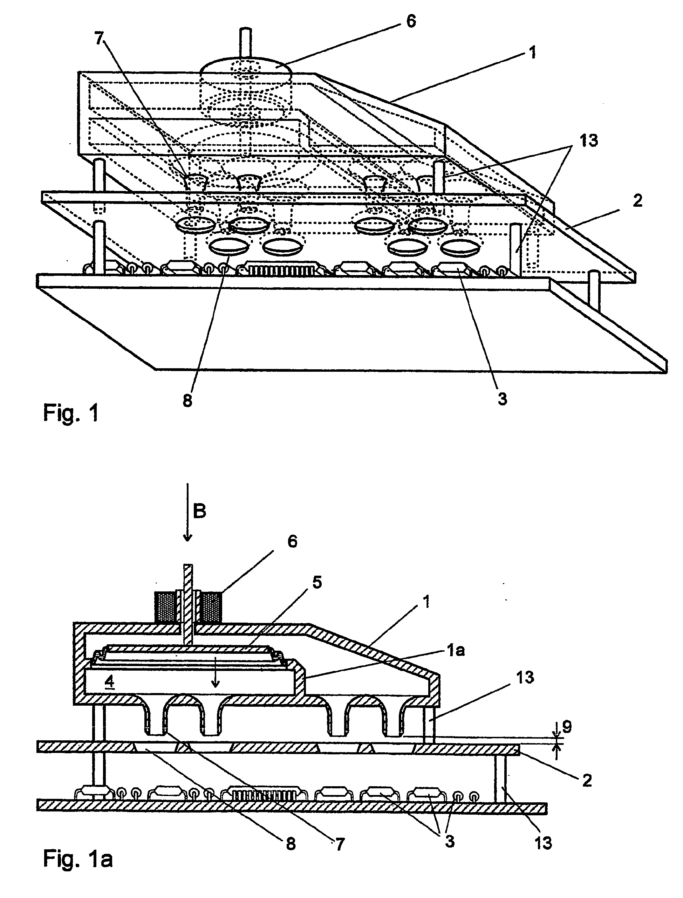

Eine erfindungsgemäße Einrichtung gemäß Fig. 1 und 1a besteht aus einer Kammer 1, neben der eine Scheidewand 2 angeordnet ist und auf deren anderen Seite sich elektrische bzw. elektronische Bauteile 3 befinden, welche mittels eines Luftstromes klimatisiert, insbesondere gekühlt, werden müssen.

In der Kammer 1 ist eine Zwischenwand 1a mit einer Membran 5 angeordnet, welche mittels eines Elektromagneten 6, in und entgegen der Richtung des Pfeiles B mit einer unterhalb der Hörfrequenz liegenden Frequenz auf - und ab verstellbar ist.

In einer Seitenwand der Kammer 1 sind trompetenförmige Bohrungen oder Öffnungen 7 ausgebildet und in der Scheidewand 2 Bohrungen oder Öffnungen 8. Die Öffnungen 7 liegen den Öffnungen 8 in einem Abstand 9 unmittelbar gegenüber. Der Durchmesser der Öffnungen 8 der Scheidewand 2 ist größer als der Durchmesser der trompetenförmigen Öffnungen 7 der Kammer 1. Weiters sind Tragebolzen 13 vorgesehen, welche die Kammer 1, die Scheidewand 2 und eine Basisplatte, auf der sich die elektrischen bzw. elektronischen Bauteile 3 befinden, miteinander verbinden.

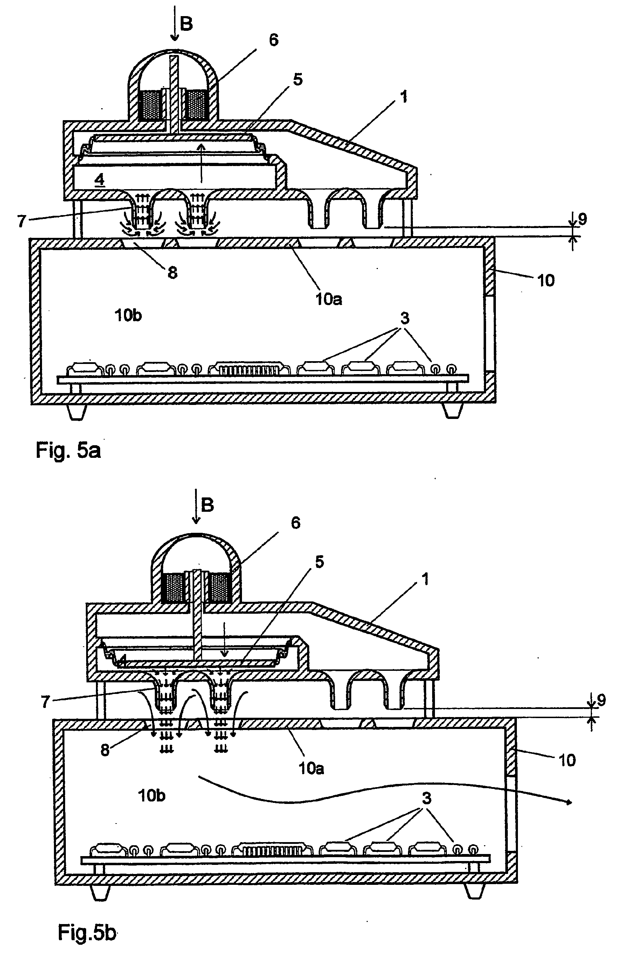

Sobald die Membran 5 mittels des Elektromagneten 6 entgegen der Richtung des Pfeiles B nach oben verstellt wird, wird durch die Öffnungen 7 in den Innenraum 4 der Kammer 1 Luft eingesaugt. Dies ist in Fig. 5a mit Bezug auf eine andere Ausführungsform schematisch dargestellt. Es ist zu sehen, dass die Luft hauptsächlich durch den Spalt zwischen der Wand des Gehäuses 1 mit den Öffnungen 7 und der Scheidewand 2 bzw. zwischen den einander zugewandten Rändern der Öffnungen 7, 8 durch die Öffnungen 7 in die Kammer 1 eingesaugt wird.

Sobald die Membran 5 mittels des Elektromagneten 6 in Richtung des Pfeiles B nach unten verstellt wird, wird aus dem Innenraum 4 der Kammer 1 durch die Öffnungen 7 Luft in Form einer gerichteten Strömung durch die Öffnungen 8 auf die andere Seite der Scheidewand 2 hinausgepresst. Dies ist in Fig. 5b dargestellt. Durch die entstehende Sogwirkung beim Herauspressen wird zusätzliche Luft aus dem Spalt zwischen der Kammer 1 und der Scheidewand 2 auf die von der Kammer abgewandte Seite der Scheidewand 2 mitgerissen, da die im dargestellten Ausführungsbeispiel als Düse ausgeführte Öffnung 7 wie ein Injektor wirkt. Die Scheidewand 2 verhindert, dass bereits durch die Öffnung 8 durchgeförderte Luft in nennenswertem Ausmaß wieder zurückströmt.

Durch das unterschiedliche Strömungsverhalten des Einsaugvorganges im Vergleich zum Ausstoßvorgang kommt es zu einer weitgehend kontinuierlichen Strömung durch die Scheidewand 2 in Richtung auf die elektrischen bzw. elektronischen Bauteile 3. Durch die Größe des Abstandes 9 bzw. des Spaltes zwischen den trompetenförmigen Öffnungen 7 der Kammer 1 und den im Querschnitt größer ausgebildeten Öffnungen 8 der Scheidewand 2 kann das Strömungsverhalten den jeweiligen Verhältnissen entsprechend optimal eingestellt werden.

Der Luftstrom bewirkt eine Klimatisierung, insbesondere eine Kühlung, der unterhalb befindlichen elektronischen Bauteile 3. Da die Frequenz der Bewegung der Membran 5 unterhalb der Hörfrequenz, z.B. 15 Hz, liegen kann, werden weder durch die Verstellung bzw. Bewegung der Membran 5 noch durch die Luftströmung hörbare oder störende Geräusche verursacht.

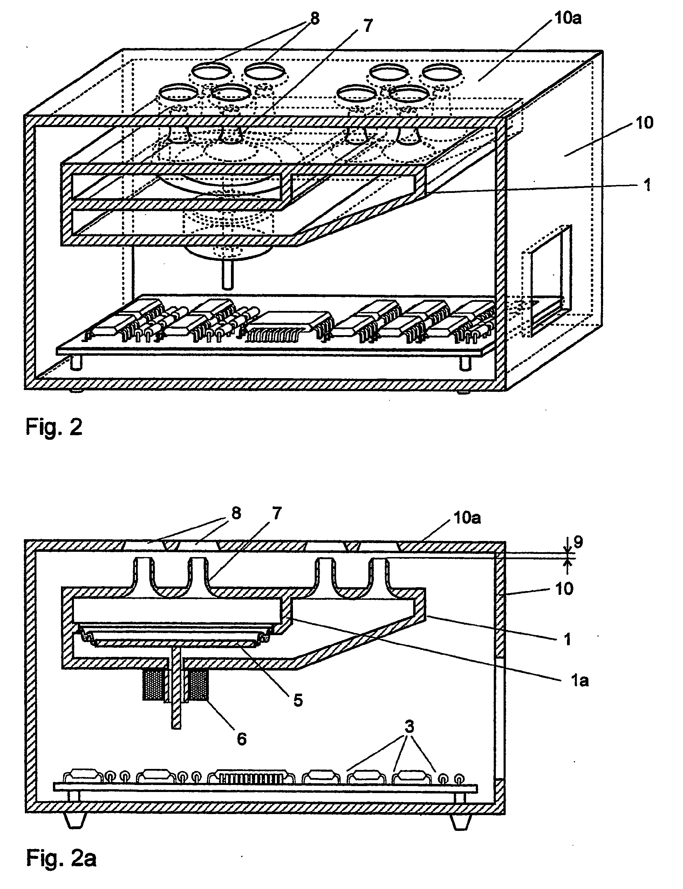

Die Ausführungsform gemäß Fig. 2 und 2a unterscheidet sich von der Ausführungsform gemäß Fig. 1 und la dadurch, dass die Kammer 1 innerhalb eines die zu kühlenden Bauteile 3 umfassenden Gehäuses 10 angeordnet ist, wobei eine Seitenwand 10a des Gehäuses als Scheidewand ausgebildet ist. Dadurch wird eine das Gehäuse 10 durchsetzende Luftströmung erzeugt, welche eine Klimatisierung der im Innenraum 10b des Gehäuses 10 befindlichen elektrischen Bauteile 3 bewirkt, die an der Scheidewand 10a aus dem Gehäuse 10 heraus gerichtet ist.

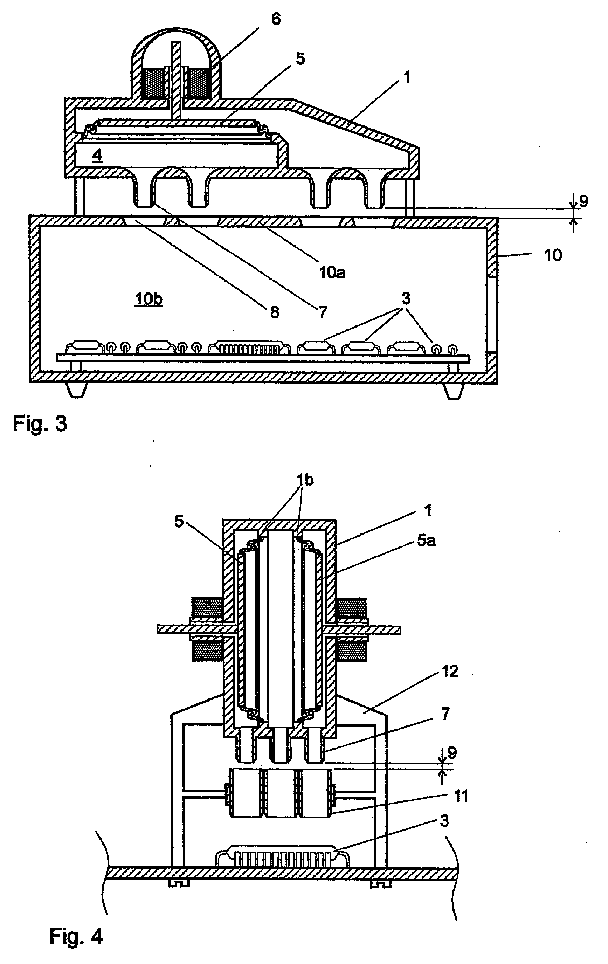

Die Ausführungsform gemäß Fig. 3 unterscheidet sich von der Ausführungsform gemäß Fig. 2 und 2a dadurch, dass die Kammer-1 außerhalb des die zu kühlenden Bauteile 3 umfassenden Gehäuses 10 angeordnet ist, wobei wieder eine Seitenwand 10a des Gehäuses als Scheidewand ausgebildet ist. Hier wird eine Luftströmung in das Innere des Gehäuses 10b erzeugt, die das Gehäuse 10 durchsetzt und durch welche eine Klimatisierung der im Innenraum 10b des Gehäuses 10 befindlichen elektrischen Bauteile 3 bewirkt wird.

Die Ausführungsform gemäß Fig. 4 unterscheidet sich von den vorhergehenden Ausführungsformen unter anderem dadurch, dass die Kammer 1 zwei Zwischenwände 1b und zwei Membrane 5 und 5a, die einander gegenüberliegen, aufweist, wobei die Membrane 5 und 5a synchron jeweils zueinander bzw. auseinander bewegt werden, um ein Schwingen der Kammer 1 zu verhindern. Die Öffnungen 7 der Kammer 1 sind rohrförmig ausgeführt. Die Scheidewand ist im Durchströmbereich in Form von rohrförmigen Kanälen bzw. Durchgängen 11 ausgeführt, wobei für jede Öffnung 7 der Kammer 1 ein rohrförmiger Durchgang 11 vorgesehen ist. Die Öffnungen 7 der Kammer 1 und die rohrförmigen Durchgänge 11 bzw. deren Ränder sind in einem Abstand 9 voneinander angeordnet. Weiters sind Tragarme 12 vorgesehen, welche die Kammer 1 und die rohrförmigen Durchgänge 11 miteinander verbinden. Durch das Verstellen bzw. Schwingen der Membrane 5 und 5a wird wieder ein Luftstrom auf den zu kühlenden Bauteil 3 erzeugt.

In Fig. 5 und 5a ist die Funktionsweise, insbesondere der auch in Fig. 3 gezeigten Ausführungsform, dargestellt. Das Funktionsprinzip der anderen Ausführungsformen der Erfindung ist aber entsprechend. Sobald die Membran 5 mittels des Elektromagneten 6 entgegen der Richtung des Pfeiles B nach oben verstellt wird, wird durch die trompetenförmigen Öffnungen 7 Luft oder Flüssigkeit von außerhalb des Gehäuses in den Innenraum 4 der Kammer 1 eingesaugt. Durch den Abstand 9 der Öffnungen 7 im Gehäuse 1 von den Öffnungen 8 in der Seitenwand 10a des Gehäuses 10, welche die Scheidewand bildet, wird die Luft weitgehend von der Außenseite des Gehäuses 10 angesaugt.

Sobald die Membran 5 mittels des Elektromagneten 6 in Richtung des Pfeiles B nach unten verstellt wird, wird durch die Öffnungen 7 aus dem Innenraum 4 der Kammer 1 Luft durch die Öffnungen 8 auf die andere Seite der Seitenwand 10a, also in das Gehäuse 10 gepresst. Durch die unterschiedliche Strömungseigenschaft bzw. das unterschiedliche Strömungsverhalten des Einsaugvorganges gegenüber dem Ausstoßvorgang und durch den Abstand 9 zwischen den trompetenförmigen Öffnungen 7 der Kammer 1 und den im Querschnitt größeren Öffnungen 8 der Seitenwand 10a des Gehäuses 10 wird ein Luftstrom durch das Gehäuse 10 bewirkt. Durch die beim Herauspressen entstehende Sogwirkung wird zusätzliche Luft in das Gehäuse mittransportiert.

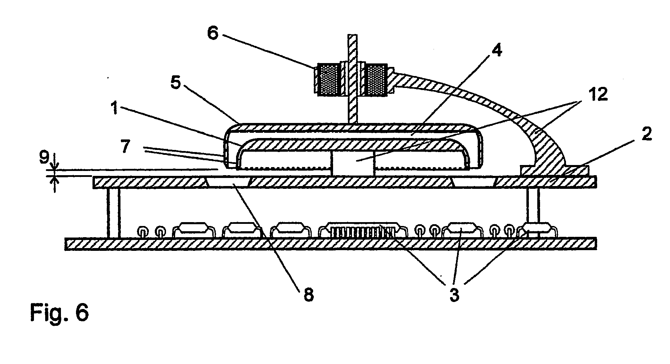

Die Ausführungsform gemäß Fig. 6 unterscheidet sich von den anderen Ausführungsformen dadurch, dass eine Wand der Kammer 1 als Membran 5 ausgeführt ist. Weiters sind Tragarme 12 für den Elektromagneten 6 und für den nicht bewegbaren Teil der Kammer 1 vorgesehen. Die Ränder des nicht bewegbaren Teils der Kammer 1 und des bewegbaren Teils der Kammer 1, der die Membran 5 bildet, bilden zusammen die Öffnung 7 der Kammer 1 in Form eines rohrförmigen Schlitzes, durch welchen Luft eingesaugt bzw. herausgepresst wird. Der rohrförmige Schlitz 7 mündet vor den Öffnungen 8 der Scheidewand 2. An Stelle von mehreren Öffnungen 8 kann auch nur eine einzige ringförmige Öffnung 8 in der Scheidewand 2 vorgesehen sein.

## Patentansprüche

1. Einrichtung zur Klimatisierung von Gehäusen, Räumen, Bauteilen, Medien u.dgl., insbesondere zur Kühlung von in elektrischen bzw. elektronischen Anlagen und Geräten befindlichen Bauelementen (3), mittels eines Fluidstroms, insbesondere eines Luft- oder Flüssigkeitsstroms, mit einer Kammer (1), welche mindestens eine verstellbare Membran (5) und wenigstens eine Öffnung (7) in einer Wand der Kammer (1) aufweist, **dadurch gekennzeichnet, dass** eine Scheidewand (2, 10a) mit wenigstens einer Öffnung (8) vorgesehen ist, die der Öffnung (7) in der Wand der Kammer (1) unmittelbar gegenüber liegt, und dass die Öffnung (7) in der Wand der Kammer (1) und die Öffnung (8) in der Scheidewand (2, 10a) durch einen Spalt (9) voneinander beabstandet sind, wobei durch die Schwingung der Membran (5) eine Fluidströmung durch die Öffnung (8) der Scheidewand (2, 10a) hindurch bewirkt wird, indem Fluid durch den Spalt (9) und durch die Öffnung (7) in der Wand der Kammer (1) in diese eingesaugt und durch die Öffnungen (7, 8) der Kammer (1) und der Scheidewand (2, 10a) aus der Kammer (1) herausgepresst wird.

2. Einrichtung nach Anspruch 1, **dadurch gekennzeichnet, dass** das Fluid durch einen Spalt (9) zwischen der Wand der Kammer (1) mit der Öffnung (7) und der Scheidewand (2, 10a) und durch die Öffnung (7) der Kammer (1) in diese eingesaugt und durch die Öffnungen (7, 8) der Kammer (1) und der Scheidewand (2, 10a) aus der Kammer (1) herausgepresst wird.

3. Einrichtung nach Anspruch 1 oder 2, **dadurch gekennzeichnet, dass** eine Gruppe von Öffnungen (7) in der Wand der Kammer (1) vorgesehen ist, der eine vorzugsweise entsprechende Anzahl von Öffnungen (8) in der Scheidewand (2, 10a) zugeordnet ist.

4. Einrichtung nach einem der Ansprüche 1 bis 3, **dadurch gekennzeichnet, dass** zwischen den einander gegenüber liegenden Öffnungen (7) der Kammer (1) und Öffnungen (8) der Scheidewand ein Abstand (9) ausgebildet ist.

5. Einrichtung nach einem der Ansprüche 1 bis 4, **dadurch gekennzeichnet, dass** der Durchmesser der Öffnungen (8) bzw. der Mündung der Öffnungen (8) in der Scheidewand (2, 10a) größer ist als der Durchmesser der Öffnungen (7) bzw. der Mündung der Öffnungen (7) der Kammer.

6. Einrichtung nach einem der Ansprüche 1 bis 5, **dadurch gekennzeichnet, dass** das Fluid durch einen zwischen den einander zugewandten Rändern der Öffnungen (7, 8) in der Wand der Kammer (1) und der Scheidewand (2, 10a) gebildeten Spalt (9) angesaugt wird.

7. Einrichtung nach einem der Ansprüche 1 bis 6, **dadurch gekennzeichnet, dass** die Öffnungen (7) der Kammer (1) rohrförmig oder kegelstumpfförmig oder trompetenförmig ausgebildet sind.

8. Einrichtung nach Anspruch 7, **dadurch gekennzeichnet, dass** die Öffnungen in der Wand der Kammer durch zylinderförmige, kegelstumpfförmige oder trompetenförmige Rohre gebildet werden.

9. Einrichtung nach Anspruch 6, **dadurch gekennzeichnet, dass** die Scheidewand (11) durch wenigstens einen, vorzugsweise mehrere rohrförmige oder kegelstumpfförmige Durchgänge gebildet wird.

10. Einrichtung nach einem der Ansprüche 1 bis 9, **dadurch gekennzeichnet, dass** die Scheidewand als Seitenwand (10a) eines die zu kühlenden Bauteile (3) umfassenden Gehäuses (10) ausgebildet ist.

11. Einrichtung nach einem der Ansprüche 1 bis 10, **dadurch gekennzeichnet, dass** die Kammer (4) durch eine Zwischenwand (1a) in zwei Räume unterteilt ist, dass die Membran (5) in der Zwischenwand angeordnet ist, und dass jeder Raum wenigstens eine Öffnung (7) aufweist, der eine Öffnung (8) in der Scheidewand (2, 10a) zugeordnet ist.

12. Einrichtung nach einem der Ansprüche 1 bis 10, **dadurch gekennzeichnet, dass** in der Kammer (1) zwei einander gegenüberliegende und zugeordnete Membrane (5, 5a) vorgesehen sind, welche synchron zueinander bzw. auseinander bewegbar sind.

13. Einrichtung nach einem der Ansprüche 1 bis 11, **dadurch gekennzeichnet, dass** die Membran (5) durch einen Wandteil der Kammer (1) gebildet wird, der relativ zu den benachbarten Teilen der Wand der Kammer (1) bewegbar ist und dass zwischen den benachbarten Rändern (7) des Wandteiles (5) und der Wand der Kammer (1) ein Spalt (9) gebildet ist, der eine im Querschnitt rohrförmige Öffnung bildet, die der Öffnung (8) in der Scheidewand (2) unmittelbar gegenüber liegt.

## Claims

1. Means for climate-control of housings, spaces, components, media and the like, especially for cooling of components (3) located in electrical and electronic systems and devices, by means of a fluid flow, especially an air or liquid flow, with a chamber (1) comprising at least one adjustable membrane (5) and at least one opening (7) in a wall of the chamber (1), **characterized in that** a partition (2, 10a) is provided with at least one opening (8), which is directly opposite the opening (8) in the wall of the chamber (1), and that the opening (7) in the wall of the chamber (1) and the opening (8) in the partition (2, 10a) are distanced from one another by a gap (9), and that by the vibration of the membrane (5) a fluid flow being caused through the opening (8) of the partition (2, 10a) by fluid being sucked into the chamber (1) through the gap (9) and through the opening (7) in the wall of the chamber (1) and being forced out of the chamber (1) through the openings (7, 8) of the chamber (1) and of the partition (2, 10a).

2. Means as claimed in claim 1, wherein the fluid is sucked into the chamber (1) through a gap (9) between the wall of the chamber (1) with the opening (7) and the partition (2, 10a) and through the opening (7) of the chamber (1) and is forced out of the chamber (1) through the openings (7, 8) of the chamber (1) and of the partition (2, 10a).

3. Means as claimed in claim 1 or 2, wherein a group of openings (7) in the wall of the chamber (1) is provided to which a preferably corresponding number of openings (8) in the partition (2, 10a) is assigned.

4. Means as claimed in one of the claims 1 to 3, wherein a distance (9) is formed between the opposing openings (7) of the chamber (1) and the openings (8) of the partition.

5. Means as claimed in claims 1 to 4, wherein the diameter of the openings (8) or of the mouth of the openings (8) in the partition (2, 10a) is greater than the diameter of the openings (7) or of the mouth of the openings (7) of the chamber.

6. Means as claimed in one of the claims 1 to 5, wherein the fluid is sucked through a gap (9) being formed between the facing edges of the openings (7, 8) in the wall of the chamber (1) and the partition (2, 10a).

7. Means as claimed in one of the claims 1 to 6, wherein the openings (7) of the chamber (1) are made tubular or in the shape of a truncated cone or trumpet-shaped.

8. Means as claimed in claim 7, wherein the openings in the wall of the chamber are formed by tubes which are cylindrical, in the shape of a truncated cone, or trumpet-shaped.

9. Means as claimed in claim 6, wherein the partition (11) is formed by at least one, preferably several passages which are tubular or are in the shape of a truncated cone.

10. Means as claimed in one of the claims 1 to 9, wherein the partition is made as a side wall (10a) of a housing (10) encompassing the components (3) to be cooled.

11. Means as claimed in one of the claims 1 to 10, wherein the chamber (4) is divided into two spaces by an intermediate wall (1a), wherein the membrane (5) is located in the intermediate wall and wherein each space has at least one opening (7) to which one opening (8) in the partition (2, 10a) is assigned.

12. Means as claimed in one of the claims 1 to 10, wherein in the chamber (1) there are two membranes (5, 5a) which are assigned to one another and are opposite one another and which can be moved synchronously toward one another or apart from one another.

13. Means as claimed in one of the claims 1 to 11, wherein the membrane (5) is formed by one wall part of the chamber (1) which can be moved relative to the adjacent parts of the wall of the chamber (1) and wherein between the adjacent edges (7) of the wall part (5) and the wall of the chamber (1) a gap (9) is formed which forms an opening tubular in cross section which is directly opposite the opening (8) in the partition (2).

## Revendications

1. Installation pour climatiser des boitiers, d'espaces, des composants (3) et des médiums etc., particulièrement a réfrigérer des composants dans des appareilles électrique ou électronique et des machines, en aide d'une écoulement d' air ou fluide, **caractérisé en ce qu'**une chambre (1) est prévue, elle est prévue avec au moins une membrane (5) ajustable et au moins d'une alésage (7), qui est tourner vers une cloison (2, 10a) d' alésages (7), par contre en déplaçant la membrane (5) un courant d'air ou de fluide est obligé de passer par les alésages (7) de la cloison (2, 10a), parce que l' air ou liquide est attiré resp. éjecté par des alésages (7) de la chambre (1) et en travers les différente charters de l'action aspiré et éjecte une écoulement d'air ou de fluide et dirige d'une panneau mural de la cloison (2, 10a) à l'autre.

2. Procédé pour revendiquer le droit d' invention 1 **caractérisé en ce que** le fluide passe une fissure dans le panneau de la chambre (1) avec la brèche et la cloison (2, 10a) et par la brèche de la chambre (1) aspiré par elle et les brèches de la chambre (1) et de la cloison (2, 10a) éjecté par la chambre (1).

3. Procédé pour revendiquer le droit d'invention 1 ou 2 **caractérisé en ce que** est prévue une groupe des mortaises (7) dans la chambre (1), quelle de préférence est classé un conforme nombre des mortaises dans le cloison (2, 10a).

4. Procédé pour revendiquer le droit d'invention 1 - 3 **caractérisé en ce que** entre les alésages (7) de la chambre (1) lesquelles se trouvent en panneau mural de la cloison (2, 10a) est prévue une distance (9).

5. Procédé pour revendiquer le droit d' invention 1, - 4 **caractérisé en ce** le diamètre des mortaises (8) resp. la bordure de la mortaise (8) dans la cloison (2, 10a) est grandir comme des mortaises (7) resp. des bordures des mortaises (7) de la chambre (1)

6. Procédé pour revendiquer le droit d' invention 1 - 5 **caractérisé en ce que** le fluide est aspirer entre de la brèche (7,8), quille est former par des bords des mortaises (7) de la chambre (1) et la cloison (2, 10a)

7. Procédé pour revendiquer le droit d' invention 1 - 6 **caractérisé en ce que** comme le cloison (2, 10a) même (11) est prévue en forme de tube ou en forme de cône obtus.

8. Procédé pour revendiquer le droit d'invention 7 **caractérisé en ce que** comme cloison (2, 10a) (11) le passage en forme de tube ou en forme de cône obtus est prévue.

9. Procédé pour revendiquer le droit d' invention 6 **caractérisé en ce que** comme le cloison (2, 10a) même (11) est prévue avec au moins en forme de une tube ou en forme de un cône obtus.

10. Procédé pour revendiquer le droit d' invention 1 - 9 **caractérisé en ce que** la cloison en même temps est la panneau mural (10a) d'une boîtier (10) de qui réfrigérer les composants (3).

11. Procédé pour revendiquer le droit d' invention 1 - 10 **caractérisé en ce que** la chambre (4) est sectionnement avec une mural (1a) en deux pièces, que la membrane (5) est prévue dans le cloison, et que en tout des pièces est prévue une brèche (8) quille est classer une brèche dans le cloison(2, 10a).

12. Procédé pour revendiquer le droit d' invention 1 - 10 **caractérisé en ce que** deux Membranes (5, 5a) sont prévue en face dans la chambre (1) lesquelles agiter rapprocher et écarte synchrone.

13. Procédé pour revendiquer le droit d' invention 1 - 11 **caractérisé en ce que** la membrane (5) est prévue par panneau mural de la chambre (1) qui agite relative à des parties de la chambre (1) avoisinant, et que entre des bordures (7) des panneau murals (5) avoisinant et la panneau mural de la chambre (1) est prévue une brèche (9) qui forme en coupe transversale une brèche (8) in forme du cône quille trouver immédiatement vis-à-vis de la brèche (8) dans le cloison (2).
